# FASCICULE DE BREVET EUROPEEN

(11) **EP 0 705 185 B1**
(45) Date de publication et mention de la délivrance du brevet: **07.01.1998**
(21) Numéro de dépôt: 94920989.4
(22) Date de dépôt: 29.06.1994
(51) Int. Cl.: B60R 25/04, H05K 5/02

(54) **BOITIER INVIOLABLE POUR UN APPAREIL ELECTRIQUE MONTE DANS UN VEHICULE A MOTEUR**
SICHERHEITSGEHÄUSE FÜR EIN IN EIN MOTORFAHRZEUG EINGEBAUTES ELEKTRISCHES GERÄT
TAMPER-PROOF HOUSING FOR AN ELECTRICAL DEVICE FITTED TO A MOTOR VEHICLE

(30) Priorité: 30.06.1993 FR 9307999
(43) Date de publication de la demande: 10.04.1996
(73) Titulaire: I.D. INGENIERIE, F-73110 La Rochette (FR)
(72) Inventeur: LOISEL, Yves, F-74000 Annecy (FR)
(74) Mandataire: Derambure, Christian
(86) Numéro de dépôt international: FR9400787
(87) Numéro de publication internationale: WO9501269

(56) Documents cités:
- EP-A- 0 232 974
- EP-A- 0 335 166
- WO-A-86/06692
- WO-A-89/07815
- CH-A- 164 069
- DE-U- 9 201 258

## Description

L'invention concerne un dispositif inviolable pour le contrôle de l'utilisation d'un appareil tel qu'une machine ou un véhicule dont le fonctionnement dépend de celui d'au moins un organe électrique, notamment électronique, faisant partie de cet appareil et qui est relié électriquement au reste de l'appareil par au moins un fil conducteur.

Dans de nombreuses applications, et plus particulièrement en ce qui concerne les véhicules à moteur, le problème se pose de contrôler avec une plus grande fiabilité l'utilisation autorisée ou non de l'appareil afin d'éviter que des personnes non autorisées ne puissent par effraction ou contre la volonté du propriétaire utiliser et mettre en fonctionnement cet appareil.

On connaît déjà de nombreux dispositifs antieffraction ou antivol, avec ou sans alarme. Ces dispositifs sont souvent constitués d'interrupteurs intégrés dans le circuit électrique de fonctionnement de l'appareil commandés par des moyens à serrure (comme par exemple les systèmes commercialisés par la Société Neiman, pour les clés de contact) ou simplement cachés sur le véhicule à un endroit quelconque non immédiatement visible. D'autres systèmes antivol, tels que décrit dans les documents EP-A-0 335 166 et WO-A-86 06602, existent (chaîne, verrou de direction, alarme...), mais tous ces dispositifs ne constituent en pratique qu'un faible obstacle pour la petite délinquance, c'est à dire pour les voleurs occasionnels.

Le document WO-A-8 907 815 décrit un appareil de sécurité pour l'immobilisation d'un véhicule, dans lequel un décodeur de tonalité et une électrovanne combustible alimentée par le décodeur de tonalité sont emboîtés dans un boîtier de telle sorte qu'ils soient inaccessibles. Le boîtier de sécurité peut comprendre une enveloppe en matériau plastique tel que de la résine époxy ou une enveloppe robuste tel que l'accès au moyen de décodage et à l'électrovanne soit limité.

Le document EP-A-0 232 974 concerne un système antivol de coupure de l'alimentation en carburant. Ce système comporte une valve de commande combustible qui comprend des moyens de commande montés dans le support de valve et destinés à la placer dans une position ouverte ou fermée.

On connaît également d'après le document CH-A- 1 640 069 un dispositif de sécurité contre l'utilisation non autorisée du véhicule automobile.

Ce dispositif comporte un boîtier dans lequel est enfermée une bobine d'allumage.

Toutes les parties du boitier ainsi que le boîtier lui-même sont reliés fortement les uns aux autres par une masse de remplissage de telle sorte que les raccordements pour les fils d'entrée et de sortie de la bobine sont inaccessibles.

Enfin, le document DE-V-9 201 258 décrit une liaison à cran non détachable pour l'adhérence et le blocage notamment de pièces thermoplastiques.

L'invention ne se pose pas le problème de lutter contre le vol organisé. En effet, dans le domaine du contrôle de l'utilisation de machines telles que des machines outils ou de véhicules tels que les véhicules à moteur et plus particulièrement les deux roues (cyclomoteurs, vélomoteurs, ou motocyclettes)la majorité des effractions et des vols provient de voleurs occasionnels qui réussissent à forcer aisément, c'est à dire en un temps bref, les dispositifs de sécurité d'origine de l'appareil.

L'invention vise donc à remédier à ce problème général, c'est à dire à proposer un dispositif de sécurité qui empêche l'utilisation non autorisée de l'appareil par un voleur occasionnel, sauf à ce que celui-ci soit obligé de réaliser une intervention mécanique longue et/ou spécifique sur l'appareil. En effet, le problème principal qui se pose dans ce contexte est d'augmenter le temps de résistance des sécurités antivol pour un voleur occasionnel. Les assurances contre le vol fournissent des homologations aux dispositifs de sécurité antivol en fonction de leur temps de résistance à l'effraction.

L'invention vise donc à proposer un tel dispositif qui soit simple de conception, peu couteux, adaptable aisément sur l'appareil, rapide à poser, qui empêche le fonctionnement de l'appareil. Le dispositif doit pouvoir être monté d'origine ou comme accessoire après vente, et être rajouté ou substitué aux dispositifs préexistants de sécurité antivol.

L'invention vise également à proposer un tel dispositif qui soit simple à utiliser et qui ne remette en aucune façon en cause la sécurité de l'utilisateur normal de l'appareil quelles que soient les pannes que ce dispositif peut subir en utilisation normale.

Pour ce faire, l'invention propose un dispositif inviolable de contrôle d'utilisation d'un appareil dont le fonctionnement dépend de celui d'au moins un organe électrique defini par les caractéristiques de la revendication 1.

L'invention propose donc un dispositif qui est simplement rajouté, d'origine ou non, autour de la connexion électrique d'un organe électrique tel qu'un circuit d'allumage électronique, un calculateur électronique ou un élément essentiel de celui-ci ou une bobine d'allumage ou autre, et qui permet de rendre inaccessible cette connexion, tout en incorporant des moyens de commande à utilisation contrôlée. Un tel dispositif peut donc se substituer mais aussi se rajouter en complément aux dispositifs antivol montés d'origine déjà connus et utilisés. Le dispositif inviolable une fois posé sur la connexion électrique empêche tout fonctionnement de l'organe électrique, et donc de l'appareil sauf à détruire au moins partiellement l'organe électrique ou sa connexion et nécessiter son remplacement pur et simple.

Selon l'invention, le boîtier recouvre une partie seulement de l'organe électrique. Cela permet ainsi de ne pas modifier la base du support de l'organe électrique (bobine d'allumage) à protéger.

Selon l'invention, les deux parties de boîtiers définissent après emboîtement un espace clos inaccessible renfermant l'organe électrique. Et les moyens d'association indémontable comprennent des moyens d'association irréversible des deux parties de boîtiers l'une sur l'autre.

Selon l'invention les moyens d'association indémontable sont inaccessibles de l'extérieur du revêtement de protection.

Selon l'invention, le dispositif comprend en variante ou en combinaison, au moins une couche de matière synthétique qui réalise au moins pour partie le revêtement de protection, et qui recouvre au moins la connexion du fil conducteur à l'organe électrique. Cette matière synthétique est, selon l'invention, durcissable et, lorsqu'elle est utilisée avec un boîtier, adhérente et interposée entre le boîtier et l'organe électrique. La matière synthétique est disposée pour noyer les connexions électriques, et plus particulièrement la connexion du fil conducteur à l'organe électrique.

La présence d'un boîtier au moins en deux parties permet ainsi soit d'effectuer une pose définitive en un matériau peu cher soit une pose d'un boîtier amovible destiné à servir uniquement de moule et donc réutilisable. Dans ce cas, une fois le matériau de moulage durci, le boîtier est retiré et peut être réutilisé.

L'invention concerne également l'application d'un tel dispositif pour réaliser une sécurité antivol de véhicules à moteur, et un véhicule - notamment à deux roues - à moteur caractérisé en ce qu'il est équipé d'un dispositif selon l'invention.

L'invention concerne également un dispositif, une application de ce dispositif, et un véhicule comprenant en combinaison tout ou partie des caractéristiques mentionnées ci-dessus ou ci-après.

D'autres caractéristiques et avantages de l'invention apparaîtront à la lecture de la description suivante qui se réfère aux figures annexées dans lesquelles :
- la figure 1 est une vue en section droite transversale d'un dispositif selon un premier mode de réalisation de l'invention après son montage sur un organe électrique tel qu'un circuit d'allumage électronique de véhicule à moteur.
- la figure 2 est une vue en perspective du dispositif de la figure 1 en cours de montage.
- la figure 3 est une vue similaire à la figure 1 d'un deuxième mode de réalisation de l'invention.
- la figure 4 est une vue similaire à la figure 2 du deuxième mode de réalisation de l'invention.
- la figure 5 est une vue en coupe axiale d'un dispositif selon un troisième mode de réalisation de l'invention après son montage sur un organe électrique constitué d'une bobine d'allumage de véhicule à moteur.
- la figure 6 est une vue en perspective d'un boîtier selon l'invention selon un quatrième mode de réalisation.

L'invention concerne un dispositif inviolable de contrôle de l'utilisation d'un appareil tel qu'un cyclomoteur ou un vélomoteur ou autres dont le fonctionnement dépend de celui d'au moins un organe électrique 8 relié électriquement au reste de l'appareil par au moins un fil conducteur 5, notamment par un fil conducteur 5 d'alimentation en énergie électrique. L'organe électrique 8 peut être constitué par exemple d'un organe électrique, notamment électronique contrôlant l'allumage d'un moteur thermique de l'appareil. Il peut être constitué d'un composant électrique, ou d'un ensemble de composants électriques ou électroniques, d'un circuit ou élément de circuit, intégré ou non. Il s'agit par exemple d'une bobine d'allumage ou d'un circuit d'allumage électronique du type de ceux largement utilisés sur les véhicules à moteur, y compris les cyclomoteurs ou les vélomoteurs. L'organe électrique 8 est nécessaire au fonctionnement de l'appareil en ce sens que si le fil conducteur 5 est coupé, l'appareil est hors de fonctionnement. Le fil conducteur 5 peut donc être constitué de tout fil conducteur électrique relié à l'organe électrique de telle façon que la liaison électrique qu'il constitue est indispensable au fonctionnement de l'appareil. Le fil conducteur 5 est relié à l'organe électrique 8 par une connexion électrique 7, généralement définitive et indémontable.

Selon l'invention, le dispositif comporte au moins un revêtement de protection 1, 4 destiné à recouvrir l'organe électrique 8 au moins en regard de la connexion 7 du fil conducteur 5 à cet organe électrique 8 de telle façon que cette connexion 7 et l'organe électrique 8 deviennent inaccessibles. Le dispositif comporte également des moyens 2, 3, 4 d'association indémontable du revêtement de protection 1, 4 à l'organe électrique 8. De la sorte, le revêtement de protection 1, 4 est associé à l'organe électrique 8 définitivement de façon indissociable, sauf à remplacer l'intégralité de l'organe électrique 8 lui-même. Le dispositif selon l'invention comporte également des moyens 9 interrupteurs (mécanique, électrique, télécommandé, codés ...) pouvant être intégrés, à l'intérieur du revêtement de protection 1, 4, au circuit électrique formé du fil conducteur 5 et de l'organe électrique 8 de façon à pouvoir ouvrir ou fermer ce circuit électrique. Les moyens 9 interrupteurs sont commandés de l'extérieur du revêtement de protection 1, 4 grâce à des moyens 10 de commande à utilisation contrôlée, entre une position active où ces moyens 9 interrupteurs relient électriquement le fil conducteur 5 et l'organe électrique 8, et une position inactive où ces moyens 9 interrupteurs isolent le fil conducteur 5 de l'organe électrique 8.

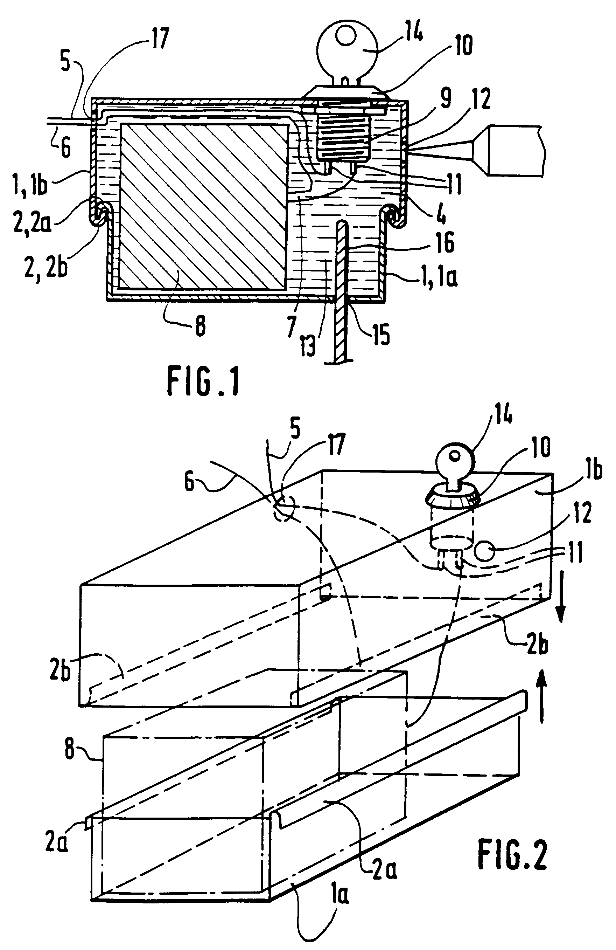

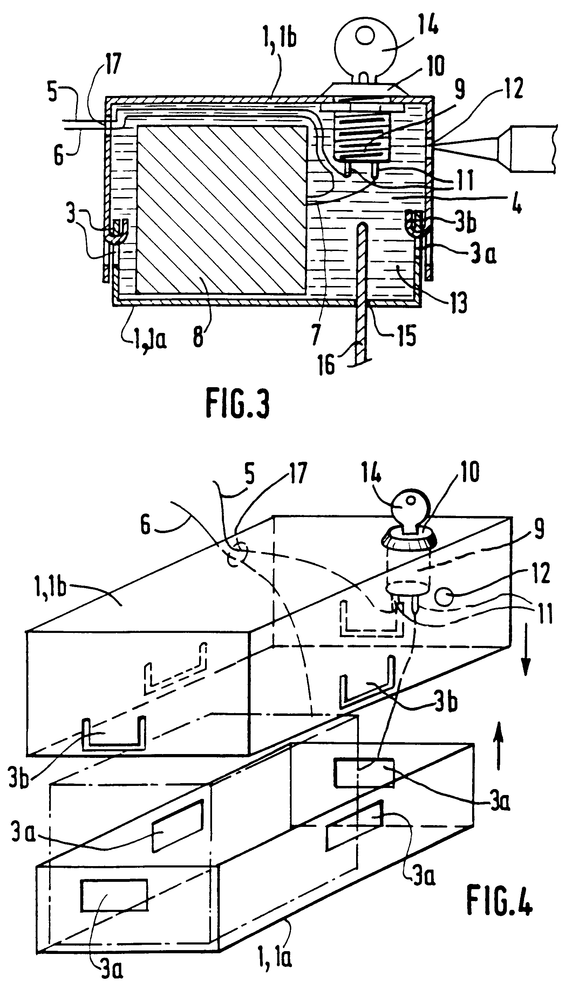

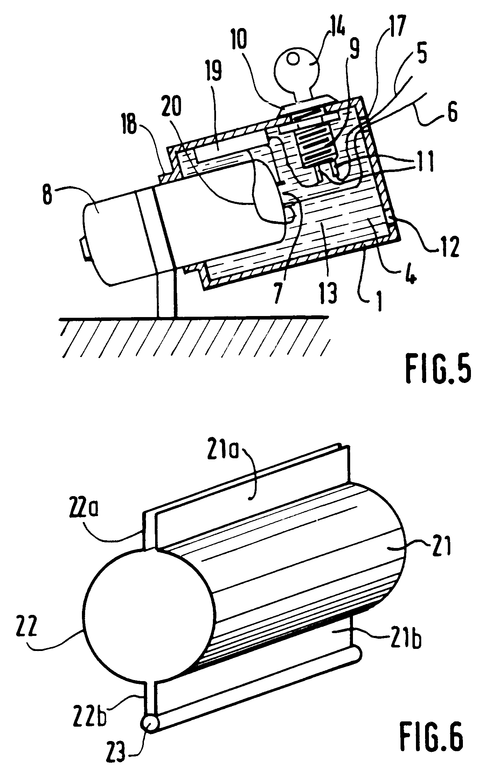

Le revêtement de protection 1, 4 comporte un boîtier 1 en matière métallique ou synthétique non immédiatement perforable, découpable ou déchirable, c'est à dire généralement rigide, dure ou blindée et/ou au moins une couche de matière synthétique 4, recouvrant l'organe électrique 8 au moins en regard de la connexion 7 du fil conducteur 5 à l'organe électrique 8. Dans les modes de réalisation représentés, les dispositifs comportent tous un boîtier 1 qui recouvre tout l'organe électrique 8 dans les deux premiers modes de réalisation des figures 1 à 4 et une partie seulement de l'organe électrique 8 dans le dernier mode de réalisation de la figure 5. Dans tous les modes de réalisation représentés, au moins une couche de matière synthétique 4 est injectée à l'intérieur du boîtier 1 pour noyer la connexion électrique 7 et l'organe électrique 8. Néanmoins la fonction du revêtement de protection 1, 4 est de rendre inaccessible la connexion électrique 7 au moins de telle sorte que toute connexion électrique intempestive ou non autorisée à l'organe électrique 8 devient impossible. Pour réaliser cette fonction, le revêtement de protection peut donc aussi bien être constitué uniquement d'un boîtier 1 ou uniquement d'une couche de matière synthétique 4 moulée sur place autour de la connexion 7 et de l'organe électrique 8. Dans ce dernier cas, les moyens 9 interrupteurs peuvent être noyés dans la matière synthétique 4. Néanmoins, la combinaison du boîtier 1 et de la couche de matière synthétique 4 procure des avantages supplémentaires puisque la matière synthétique 4 a également pour fonction de participer à l'association rigide du boîtier 1 à l'organe électrique 8 et à l'appareil, le boîtier 1 permettant de supporter les moyens 9 interrupteurs de façon plus fiable, l'ensemble devenant totalement inviolable sauf destruction.

Ainsi, la matière synthétique 4 qui recouvre l'organe électrique 8 est durcissable c'est à dire est posée à l'état liquide ou pâteux et subit une transformation qui la rend non immédiatement perforable, découpable ou déchirable, de sorte qu'elle réalise au moins pour partie le revêtement de protection 1, 4. Par ailleurs la matière synthétique 4 est adhérente et réalise au moins pour partie les moyens d'association indémontable du révêtement 1, 4 à l'organe électrique 8. Ainsi une telle couche de matière synthétique 4 adhérente peut être interposée entre un boîtier 1 et l'organe électrique 8 pour réaliser au moins pour partie les moyens 2, 3, 4 d'association indémontable du boîtier 1 à l'organe électrique 8. Selon l'invention, la matière synthétique 4 est disposée pour noyer les connexions électriques 7, 11 (dans le boîtier 1 lorsque celui-ci est prévu) - notamment au moins la connexion 7 du fil conducteur 5 à l'organe électrique 8 - et également dans les modes de réalisation représentés les connexions électriques 11 des moyens 9 interrupteurs. Selon l'invention, la matière synthétique 4 est une matière expansible fluide adhérente et durcissable injectée à travers un orifice 12 du boîtier 1 après son montage autour de l'organe électrique 8. On peut aussi utiliser une matière synthétique liquide, semi-liquide ou pâteuse placée à l'intérieur du boîtier 1 avant son montage autour de l'organe électrique 8 à la manière d'une colle. La matière synthétique 4 peut ainsi être constituée d'une résine ou d'une mousse qui, après réticulation, constitue un bloc de matière dur et rigide. On peut par exemple ainsi utiliser une mousse polyuréthanne à prise rapide. Selon l'invention, le boîtier 1 peut être constitué d'une matière synthétique compatible avec ladite matière synthétique adhérente 4 pour réaliser une adhérence forte de cette matière synthétique adhérente 4 au boîtier 1. La matière synthétique adhérente 4 est également choisie en fonction de la matière constituant les parois extérieures de l'organe électrique 8, qui sont également généralement en matière synthétique.

Dans les deux premiers modes de réalisation des figures 1 à 4, et selon l'invention, le boîtier 1 est formé au moins de deux parties de boîtier 1a, 1b - notamment de deux demi-boîtiers - de formes complémentaires pour pouvoir s'emboiter l'une dans l'autre ou sur l'organe électrique 8 à la façon d'un couvercle sur un fond en emprisonnant au moins une partie de l'organe électrique 8 et la connexion 7 du fil conducteur 5 à cet organe électrique 8. Le cas échéant, on peut prévoir un boîtier 1 formé de plus de deux parties de formes complémentaires s'emboîtant les unes dans les autres. Les parties de boîtier 1a, 1b peuvent aussi en variante être articulées l'une à l'autre avant montage. Elles peuvent aussi être fabriquées d'une seule pièce comprenant une charnière film.

Les parties de boîtier 1a, 1b définissent, après emboîtement, un espace clos inaccessible 13 renfermant l'organe électrique 8.

Et selon l'invention, les moyens 2, 3, 4 d'association indémontable comprennent des moyens 2, 3 d'association irréversible des parties de boîtier 1a, 1b l'une sur l'autre.

Dans le premier mode de réalisation des figures 1 et 2, le boîtier 1 est constitué de deux demi-boîtiers 1a, 1b dont l'un la forme un fond alors que l'autre 1b forme un couvercle. Les dimensions respectives de chacun des demi-boîtiers 1a, 1b l'un par rapport à l'autre sont sans importance dès lors que les deux demi-boîtiers 1a, 1b sont de formes complémentaires pour être emboîtés et associés rigidement de façon irréversible l'un sur l'autre en réalisant l'espace clos 13. Les moyens 2 d'association irréversible sont des moyens 2 d'encliquetage des deux demi-boîtiers 1a, 1b l'un sur l'autre et ces moyens 2 d'encliquetage sont inaccessibles de l'extérieur du boîtier 1 après l'encliquetage. Ces moyens d'encliquetage peuvent être constitués d'au moins une bande 2a du demi-boîtier la formant fond repliée vers l'extérieur le long d'un de ces bords, et d'au moins une bande 2b de forme et dimension complémentaires ménagée sur le boîtier 1b formant couvercle et repliée vers l'intérieur pour venir s'engager et coopérer par encliquetage avec la bande 2a. Les bandes 2a, 2b peuvent être constituées de replis ménagés le long de deux bords extrêmes libres opposés des deux demi-boîtiers 1a, 1b. Ces bandes peuvent s'étendre le long de tout un bord du demi-boîtier 1a, 1b ou seulement sur une partie de longueur de ces bords. On peut prévoir ainsi plusieurs bandes formant plusieurs crochets d'encliquetage régulièrement répartis à la périphérie de chacun des demi-boîtiers 1a, 1b. Ainsi, lorsque l'on emboîte les deux demi-boîtiers 1a, 1b l'un dans l'autre comme représenté par les flèches à la figure 2, les bandes 2a du demi-boîtier 1a pénètrent à l'intérieur du demi-boîtier 1b jusqu'à dépasser les bandes 1b de ce demi-boîtier 1b et à venir s'engager dans la gorge qu'elles forment comme représenté à la figure 1. A partir de cette position, toute dissociation des deux demi-boîtiers 1a, 1b l'un par rapport à l'autre devient impossible.

Selon l'invention, le boîtier 1 épouse les formes extérieures de l'organe électrique 8 qu'il recouvre avec un jeu moyen inférieur à 1 cm et notamment compris entre 1 et 5 mm. Cette disposition est plus particulièrement prévue lorsque la couche de matière synthétique adhérente 4 n'est pas utilisée. En effet, l'organe 8 remplissant la quasi totalité du boîtier 1, il n'est pas possible d'enfoncer ou d'écraser le boîtier 1 vers l'intérieur en vue de la dissociation des parties de boîtier.

Par contre, lorsque la matière synthétique 4 adhérente est utilisée, cette disposition n'est plus strictement indispensable dans la mesure où la matière synthétique 4 empêche d'elle-même tout renfoncement du boîtier 1 vers l'intérieur. Dans ces conditions, on comprend que l'on peut prévoir une forme normalisée de boîtier 1 compatible avec plusieurs formes différentes d'organe électrique 8 ce qui diminue les coûts de fabrication et simplifie le choix du dispositif pour l'utilisateur en fonction de l'appareil.

Les moyens 9 interrupteurs comportent un interrupteur bi-stable à deux bornes 11 de connexion pour pouvoir être placé en série sur le fil conducteur 5. Cet interrupteur peut être constitué d'un interrupteur mécanique, d'un relais, d'une diode, d'un transistor ou autre. Les moyens 10 de commande à utilisation contrôlée peuvent être constitués d'une serrure à barillet montée sur le boîtier 1 et commandée par une clé 14. Dans les modes de réalisation représentés sur les figures, l'interrupteur 9 et la serrure 10 sont constitués d'un seul et même dispositif, la rotation de la clé 14 modifiant la position de l'interrupteur 9 mécanique intégré dans le barillet entre les bornes 11 de connexion. La serrure mécanique 10 peut bien évidemment être remplacée par tout autre système équivalent, par exemple par une serrure électronique, ou magnétique, ou un dispositif de verrouillage à code confidentiel, ou par des moyens de commande à distance par liaison codée à ondes radio ou infrarouges ou lecture composée de deux séries d'informations telles que les caractéristiques du véhicule... Par exemple, le boîtier 1 peut contenir un récepteur d'ondes radio alimenté en énergie électrique par le fil conducteur 5, et incorporant un interrupteur 9 électronique, et pouvant être commandé de l'extérieur par un émetteur d'ondes radio livré à l'utilisateur avec le dispositif. Les moyens de commande à distance par liaison codée peuvent être également combinés à une serrure 10 mécanique, électronique ou magnétique.

Par ailleurs, et plus particulièrement lorsque le boîtier 1 englobe l'intégralité de l'organe électrique 8, le boîtier 1 comporte une lumière 15 pour l'introduction d'une patte de fixation 16 solidaire de l'appareil. Ainsi, la patte de fixation 16 est insérée à l'intérieur du boîtier 1 par la lumière 15 et des moyens de fixation sont prévus pour solidariser le boîtier 1 à la patte de fixation 16. Dans les modes de réalisation représentés aux figures 1 à 4, ces moyens de fixation peuvent être simplement constitués de la matière synthétique adhérente 4 qui, en adhérant à la fois au boîtier 1 et à la patte 16 solidarise ces deux pièces l'une sur l'autre. D'autres moyens de fixation peuvent être prévus, par exemple des moyens d'encliquetage de la patte 16 dans la lumière 15 ou un rivetage, un boulonnage, une soudure ...

Le deuxième mode de réalisation représenté sur les figures 3 et 4 diffère du premier mode de réalisation représenté sur les figures 1 et 2 en ce que les moyens 2 d'encliquetage sont remplacés par des moyens 3 d'association irréversible comprenant au moins une languette 3b découpée dans une paroi de l'une des parties de boîtier 1b pouvant être insérée dans au moins une perforation correspondante 3a de l'autre partie de boîtier 1a, la languette 3b étant repliée contre la face interne de la paroi de cette autre partie de boîtier 1a. Les languettes 3b sont ménagées dans le demi-boîtier 1b s'emboîtant à l'extérieur de l'autre demi-boîtier 1a, de sorte que ces languettes 3b sont repliées à l'intérieur des perforations 3a et du boîtier l et deviennent inaccessibles après avoir été repliées. Le nombre, les dimensions et les formes des languettes 3b et des perforations 3a sont définis de façon appropriée en fonction des formes et dimensions des demi-boîtiers 1a, 1b. Dans le mode de réalisation représenté, les deux demi-boîtiers sont de forme globalement parallélépipédique et on a prévu une languette 3b et une perforation 3a sur chacun des chants latéraux du boîtier 1. La languette 3b une fois repliée à l'intérieur du boîtier 1 devient inaccessible et il est en pratique impossible de la déplier. Par ailleurs, on peut là encore injecter de la matière synthétique adhérente 4 à l'intérieur du boîtier 1 comme représenté sur les figures.

Le boîtier 1 comporte également un orifice 17 pour la sortie des fils conducteurs électriques reliés aux éléments électriques incorporés à l'intérieur du boîtier 1, à savoir notamment le fil conducteur 5 d'alimentation électrique de l'organe électrique 8 et un fil conducteur 6 relié également à l'organe électrique 8 et véhiculant un signal de commande pour l'appareil, par exemple le signal d'allumage du moteur. Selon l'invention, l'orifice 17 de sortie des fils conducteurs 5, 6 est ménagé à l'opposé de l'orifice 12 par lequel la matière synthétique adhérente 4 est injectée à l'intérieur du boîtier 1, c'est à dire que les connexions électriques 7, 11 à l'intérieur du boîtier 1 sont interposées entre ces deux orifices 12, 17. De la sorte, lorsque l'on injecte la matière synthétique adhérente 4 à l'intérieur du boîtier par l'orifice 12, on s'assure de ce que les connexions électriques 7, 11 sont noyées dans cette matière synthétique adhérente 4 lorsque celle-ci déborde à l'extérieur de l'orifice 17 de sortie des conducteurs 5, 6.

La figure 5 représente le troisième mode de réalisation de l'invention dans lequel le boîtier 1 est constitué d'une seule pièce associée rigidement à l'extrémité d'une bobine d'allumage cylindrique 8. Le boîtier 1 définit avec la partie de l'organe électrique 8 qu'il entoure, un espace clos 13. Le boîtier 1 comporte un col cylindrique 18 venant au contact de la surface extérieure cylindrique de la bobine 8. Il serait aussi possible dans ce mode de réalisation de prévoir des moyens 2, 3 d'association irréversible du boîtier 1 à l'organe 8 de type mécanique et inaccessibles de l'extérieur après montage. Néanmoins, on voit sur la figure 5 que l'injection de matière synthétique adhérente 4 à l'intérieur du boîtier 1 par l'orifice 12 suffit à solidariser l'organe électrique 8 au boîtier 1 de façon indémontable par collage, tout en noyant les connexions électriques 7, 11 à l'intérieur du boîtier 1.

Le dispositif selon l'invention comporte également un circuit électronique 19 interne (c'est à dire placé à l'intérieur du boîtier 1) déclenchant automatiquement la mise en position inactive des moyens 9 interrupteurs en cas de détection d'au moins un événement prédéterminé. Par exemple, le circuit électronique 19 peut comporter un interrupteur complémentaire placé en série sur le conducteur 5 et le circuit électrique du conducteur 5. Le circuit électronique 19 peut comporter une temporisation qui déclenche la mise en position inactive de cet interrupteur après une période de temps prédéterminée. L'événement prédéterminé peut être simplement l'arrêt de l'émission du signal de commande dans le conducteur 6, c'est à dire par exemple correspondre à l'arrêt du moteur de l'appareil. Ainsi, le circuit électronique 19 est relié par un fil 20 conducteur au fil conducteur 6 pour recevoir le signal de commande. L'événement prédéterminé peut être d'une autre nature et par exemple une détection d'effraction ou autre. Ce circuit électronique 19 peut également être prévu dans les autres modes de réalisation de l'invention. Plus généralement, les différents modes de réalisation et variantes de l'invention peuvent être combinés.

Comme le montre la figure 6, le boîtier représenté en figure 5 peut également être en deux parties 21, 22.

Ces deux parties sont semi-cylindriques et présentent à chaque extrémité des rebords 21a, 21b, et 22a, 22b respectivement en regard.

Deux rebords 21b, 22b sont fixés entre eux de manière articulée par l'intermédiaire d'un tube 23, les deux autres rebords 21a et 22a étant libres avant le montage. Ainsi, au cours du montage, on écarte les deux parties 21 et 22 de manière à introduire la bobine d'allumage 8 dans l'espace tubulaire qu'elles définissent.

On resserre ensuite les deux parties 21, 22 en rapprochant les deux bords libres 21a et 22b et en les fixant l'un à l'autre de manière indissociable.

On peut ainsi recouvrir une partie seulement de la bobine 8, à savoir celle où sont présentes les connexions vitales, sans avoir à modifier la base de support 24 de la bobine (figure 5).

Le boîtier tel que représenté figure 6 sert ainsi de moule à injection positionné autour de l'organe électrique 8 à protéger. Ce moule constitué des deux parties 21 et 22 articulées permet le surmoulage de l'organe électrique 8 en "coiffant" une partie de ce dernier.

Compte tenu de sa forme de réalisation, le boîtier 1 de la figure 6 peut épouser des formes différentes selon les besoins.

Ainsi, après injection de la matière synthétique et après durcissement de cette dernière, l'organe 8, les moyens interrupteurs 9, les connexions 5, 6 et 7 et le circuit électronique 19 sont entièrement enrobés de cette matière synthétique et rendus solidaires et inaccessibles et le moule ou boîtier 1 peut être retiré.

L'invention concerne donc l'application d'un tel dispositif pour réaliser une sécurité antivol de véhicules à moteur, ainsi qu'un véhicule - notamment à deux roues - à moteur, par exemple y compris un cyclomoteur ou un vélomoteur qui est équipé d'un dispositif selon l'invention. Selon l'invention, un dispositif antivol est associé à la bobine d'allumage et/ou au circuit intégré de contrôle d'allumage du véhicule et/ou tout autre organe électrique contrôlant le fonctionnement du moteur du véhicule.

Le dispositif selon l'invention permet de mettre en oeuvre un procédé de renforcement de la protection antivol d'un appareil tel qu'un véhicule à moteur - notamment et y compris à deux roues - à moteur dont le fonctionnement dépend de celui d'au moins un organe électrique 8 relié électriquement à l'appareil par au moins un fil conducteur 5, caractérisé en ce qu'on insère des moyens 9 interrupteurs entre le fil conducteur 5 et l'organe électrique 8, et on recouvre par au moins un revêtement de protection 1, 4 au moins la portion de l'organe électrique 8 en regard de la connexion 7 du fil conducteur 5 et les moyens 9 interrupteurs pour les rendre inaccessibles en autorisant la commande des moyens 9 interrupteurs de l'extérieur du revêtement de protection 1, 4 par des moyens 10 de commande à utilisation contrôlée. Selon l'invention, on associe rigidement de façon indémontable le revêtement de protection 1, 4 à l'organe électrique 8. Selon l'invention, et dans le cas d'un procédé mis en oeuvre sur un véhicule déjà fabriqué, on sectionne le fil conducteur 5, on connecte les deux parties sectionnées du fil connecteur 5 à des bornes de connexion 11 d'un interrupteur 9 intégré à l'intérieur d'un boîtier 1, on passe les fils conducteurs 5, 6 sortant de la connexion 7 de l'organe électrique 8 par un orifice 17 du boîtier 1, on monte le boîtier 1 sur l'organe électrique 8, puis on injecte une matière synthétique adhérente 4 à l'intérieur du boîtier 1 par un orifice 12 jusqu'à noyer intégralement les connexions électriques 7, 11. En variante ou en combinaison, on monte le boîtier 1 sur l'organe électrique 8 grâce à des moyens d'association irréversible et inaccessibles de l'extérieur du boîtier 1 après montage.

## Revendications

1. Dispositif inviolable de contrôle de l'utilisation d'un appareil dont le fonctionnement dépend de celui d'au moins un organe électrique (8) relié électriquement au reste de l'appareil par au moins un fil conducteur (5), comportant au moins un revêtement de protection (1,4) destiné à recouvrir l'organe électrique (8) de telle façon que la connexion (7) du fil conducteur (5) à cet organe électrique (8) devienne inaccessible, des moyens (2, 3, 4) d'association indémontable de ce revêtement de protection (1, 4) à l'organe électrique (8), et des moyens (9) interrupteurs pouvant être intégrés au circuit électrique formé du fil conducteur (5) et de l'organe électrique (8) à l'intérieur du revêtement de protection (1, 4) et commandés de l'extérieur du revêtement de protection (1, 4) par des moyens (10) de commande à l'utilisation contrôlée entre une position active où les moyens (9) interrupteurs relient électriquement le fil conducteur (5) et l'organe électrique (8) et une position inactive où les moyens (9) interrupteurs isolent le fil conducteur (5) de l'organe électrique (8), le revêtement de protection (1, 4) comportant un boîtier (1) qui définit après son montage sur l'organe électrique (8), un espace clos inaccessible (13) caractérisé en ce que l'espace clos (13) renferme au moins la connexion (7) du fil conducteur (5) à l'organe électrique (8) et le boîtier est formé au moins de deux parties de boîtier (1a, 1b) de formes complémentaires, l'une des parties pouvant être constituée de la surface extérieure de l'organe électrique lui-même (8), pour pouvoir s'emboîter l'une dans l'autre ou sur l'organe électrique (8) en emprisonnant au moins une partie de l'organe électrique (8) et la connexion (7) du fil conducteur (5) à cet organe électrique (8).

2. Dispositif selon le revendication 1 caractérisé en ce que le boîtier (1) recouvre une partie seulement de l'organe électrique (8).

3. Dispositif selon la revendication 1 ou 2 caractérisé en ce que les moyens (2, 3, 4) d'association indémontable comprennent des moyens (2, 3) d'association irréversible des parties de boîtier (1a, 1b) l'une sur l'autre.

4. Dispositif selon la revendication 3 caractérisé en ce que les moyens (2, 3) d'association irréversible comportent des moyens (2) d'encliquetage des parties de boîtiers (1a, 1b) l'une sur l'autre inaccessibles de l'extérieur du boîtier (1) après l'encliquetage.

5. Dispositif selon l'une des revendications 3 et 4 caractérisé en ce que les moyens (3) d'association irréversible comportent au moins une languette (3a) découpée dans une paroi d'une partie de boîtier (1b) pouvant être insérée dans au moins une perforation (3a) de l'autre partie de boîtier (1a) et repliée contre la face interne de la paroi de cet autre partie de boîtier (1a).

6. Dispositif selon l'une des revendications 1 à 5 caractérisé en ce que le boîtier (1) épouse les formes extérieures de l'organe électrique (8) qu'il recouvre avec un jeu moyen inférieur à 1 cm, notamment compris entre 1 et 5 mm.

7. Dispositif selon l'une des revendications 1 à 6 caractérisé en ce qu'il comprend au moins une couche de matière synthétique (4) recouvrant l'organe électrique (8) au moins en regard de la connexion (7) du fil conducteur (5) à cet organe électrique (8), et qui réalise au moins pour partie le revêtement de protection (1, 4).

8. Dispositif selon la revendication 7 caractérisé en ce que la couche de matière synthétique (4) est moulée sur place autour de la connexion (7) de l'organe électrique (8) de telle sorte que cette couche de matière synthétique (4) constitue à elle seule le revêtement de protection.

9. Dispositif selon la revendication 7 ou 8 caractérisé en ce que la matière synthétique (4) est durcissable.

10. Dispositif selon l'une des revendications 1 à 9 caractérisé en ce qu'au moins une couche de matière synthétique adhérente (4) est interposée entre le boitier (1) et l'organe électrique (8) pour réaliser au moins pour partie les moyens (2, 3, 4) d'association indémontable.

11. Dispositif selon l'une des revendications 7 à 10 caractérisé en ce que la matière synthétique (4) est disposée pour noyer les connexions électriques (7, 9) - notamment au moins la connexion (7) du fil conducteur (5) à l'organe électrique (8) -.

12. Dispositif selon la revendication 1 et l'une des revendications 7 à 11 caractérisé en ce que la matière synthétique (4) est une matière durcissable injectée à travers un orifice (12) du boîtier (1) après son montage.

13. Dispositif selon la revendication 12 caractérisé en ce que le boîtier (1) est en matière synthétique compatible avec la matière synthétique adhérente (4) pour réaliser une adhérence forte.

14. Dispositif selon l'une des revendications 1 à 13 caractérisé en ce que les moyens (10) de commande à utilisation contrôlée comportent une serrure (10) mécanique ou à clé électronique et/ou des moyens de commande à distance par liaison codée.

15. Dispositif selon l'une des revendications 1 à 14 caractérisé en ce que les moyens (9) interrupteurs comportent un interrupteur bi-stable à deux bornes (11) de connexion pour pouvoir être placé en série sur le fil conducteur (5).

16. Dispositif selon l'une des revendications 1 à 15 caractérisé en ce que le boîtier (1) comporte une lumière (15) pour l'introduction d'une patte de fixation (16) à l'appareil.

17. Dispositif selon l'une des revendications 1 à 16 caractérisé en ce qu'il comporte un circuit électronique (19) interne déclenchant automatiquement la mise en position inactive des moyens (9) interrupteur en cas de détection d'au moins un événement prédéterminé.

18. Véhicule - notamment y compris à deux roues - à moteur caractérisé en ce qu'il est équipé d'un dispositif selon l'une des revendications 1 à 17.

## Claims

1. Tamper-proof device for controlling the use of an apparatus whose operation depends on that of at least one electrical component (8) connected electrically to the rest of the apparatus by at least one wire (5), equipped with at least one protective covering (1, 4) designed to cover the electrical component (8) such that the connection (7) of the wire (5) to this electrical component (8) is made inaccessible, unremovable means (2, 3, 4) for joining this protective covering (1, 4) to the electrical component (8), and switching means (9) which may be connected to the electrical circuit formed by the wire (5) and the electrical component (8) inside the protective covering (1, 4) and switched from the outside of the protective covering (1, 4) by a controlled-use control means (10) between an active position where the switching means (9) make the electrical connection between the wire (5) and the electrical component (8) and an inactive position where the switching means (9) isolate the wire (5) from the electrical component (8), the protective covering (1, 4) comprising a case (1) which forms after its assembly on the electrical component (8), an inaccessible closed space (13) characterized by the fact that the closed space (13) contains at least the connection (7) of the wire (5) to the electrical component (8) and the case comprises at least two case parts (1a, 1b) of complementary shape, one of the parts possibly being formed by the external surface of the electrical component itself (8), to allow it to fit into each other or onto the electrical component (8) while enclosing at least part of the electrical component (8) and the connection (7) of wire (5) to the electrical component (8).

2. Device according to claim 1, characterized by the fact that the case (1) covers only part of the electrical component (8).

3. Device according to claim 1 or 2, characterized by the fact that the non-removable joining means (2, 3, 4) comprise means (2, 3) for irreversibly joining case parts (1a, 1b) to each other.

4. Device according to claim 3, characterized by the fact that irreversible joining means (2, 3) comprise means (2) for snapping case parts (1a , 1b) together which are inaccessible from the outside of the case (1) after snapping together.

5. Device according to either claim 3 or 4, characterized by the fact that the irreversible joining means (3) comprise at least one tab (3a) cut out of a case part (1b) which may be inserted into at least one hole (3a) on the other part of the case (1a) and bent against the other internal surface of the side of this other part of the case (1a).

6. Device according to one of the claims 1 to 5, characterized by the fact that case (1) matches the external shapes of the electrical component (8) which it covers with an average clearance of less than 1 cm, and particularly within 1 to 5 mm.

7. Device according to one of the claims 1 to 6, characterized by the fact that it comprises at least one coat of synthetic material (4) which covers the electrical component (8) at least at the connection (7) of the wire (5) to this electrical component (8), and which constitutes at least part of the protective covering (1, 4).

8. Device according to claim 7, characterized by the fact that the coat of synthetic material (4) is molded in-situ around the connection (7) of the electrical component (8) such that this coat of synthetic material (4) alone constitutes the protective covering.

9. Device according to claim 7 or 8, characterized by the fact that the synthetic material (4) is hardenable.

10. Device according to one of the claims 1 to 9 characterized by the fact that at least one coat of adhesive synthetic material (4) is placed between the case (1) and the electrical component (8) to form at least part of the unremovable joining means (2, 3, 4).

11. Device according to one of the claims 7 to 10, characterized by the fact that the synthetic material (4) is applied to embed electrical connections (7, 9) - in particular at least connection (7) of wire (5) to electrical component (8) -.

12. Device according to claim 1 and one of the claims 7 to 11, characterized by the fact that the synthetic material (4) is a hardenable material injected through a hole (12) in the case (1) after it is assembled.

13. Device according to claim 12, characterized by the fact that the case (1) is made of a synthetic material compatible with the adhesive synthetic material (4) to obtain a strong adhesion.

14. Device according to one of the claims 1 to 13, characterized by the fact that the controlled use means (10) comprise a mechanical key (10) or an electronic key and/or a remote-control means with coded transmission link.

15. Device according to one of the claims 1 to 14, characterized by the fact that the switching means (9) comprise a two-state switch with two connection terminals (11) to enable series connection on the wire (5).

16. Device according to one of the claims 1 to 15, characterized by the fact that the case (1) comprises an oblong hole (15) for inserting a mounting bracket (16) into the apparatus.

17. Device according to one of the claims 1 to 16, characterized by the fact that it comprises an internal electronical circuit (19) which automatically triggers the switching of the switching means (9) to the inactive position if at least one pre-determined event is detected.

18. Motor vehicle - including two-wheel - characterized by the fact that it is equipped with a device according to one of the claims 1 to 17.

## Patentansprüche

1. Unverletzliche Kontrollvorrichtung für die Verwendung eines Geräts, dessen Funktionsweise von derjenigen mindestens eines elektrischen Organs (8) abhängig ist, das mit dem Rest des Geräts mit mindestens einem leitenden Draht (5) elektrisch verbunden ist, mit mindestens einer Schutzbeschichtung (1, 4), die das elektrische Organ (8) so überdecken soll, dass der Anschluss (7) des leitenden Drahts (5) an diesem elektrischen Organ (8) unzugänglich wird, undemontierbaren Verbindungsmitteln (2, 3, 4) dieser Schutzbeschichtung (1, 4) mit dem elektrischen Organ (8), und Schaltermitteln (9), die in den vom leitenden Draht (5) und dem elektrischen Organ (8) innerhalb der Schutzbeschichtung (1,4) gebildeten Stromkreis integriert werden können, und ausserhalb der Schutzbeschichtung (1, 4) von Steuermitteln (10) gesteuert werden, für die kontrollierte Verwendung zwischen einer aktiven Position, in der die Schaltermittel (9) den leitenden Draht (5) und das elektrische Organ (8) elektrisch miteinander verbinden, und einer inaktiven Position, in der die Schaltermittel (9) den leitenden Draht (5) vom elektrischen Organ (8) trennen, wobei die Schutzbeschichtung (1, 4) einen Kasten (1) umfasst, der nach seiner Montage am elektrischen Organ (8) einen unzugänglichen, geschlossenen Raum (13) definiert, dadurch gekennzeichnet, dass der geschlossene Raum (13) zumindest den Anschluss (7) des leitenden Drahts (5) am elektrischen Organ (8) beinhaltet, und dass der Kasten aus mindestens zwei Kastenteilen (1a, 1b) von sich ergänzenden Formen besteht, wobei einer der Teile aus der äusseren Oberfläche des elektrischen Organs selbst (8) bestehen kann, um sich eins in das andere oder am elektrischen Organ (8) einrasten zu können, durch Festhalten mindestens eines Teils des elektrischen Organs (8) und des Anschlusses (7) des leitenden Drahts (5) an diesem elektrischen Organ (8).

2. Vorrichtung nach Anspruch 1, dadurch gekennzeichnet, dass der Kasten (1) nur einen Teil des elektrischen Organs (8) abdeckt.

3. Vorrichtung nach Anspruch 1 oder 2, dadurch gekennzeichnet, dass die Mittel (2, 3, 4) der undemontierbaren Verbindung Mittel (2, 3) zur nicht umkehrbaren Verbindung der Kastenteile (1a, 1b) eins auf dem anderen umfassen.

4. Vorrichtung nach Anspruch 3, dadurch gekennzeichnet, dass die Mittel (2, 3) der nicht umkehrbaren Verbindung Mittel (2) zum Einrasten der Kastenteile (1a, 1b) eins auf dem anderen umfassen, die nach Einrasten von ausserhalb des Kastens (1) nicht zugänglich sind.

5. Vorrichtung nach einem der Ansprüche 3 und 4, dadurch gekennzeichnet, dass die Mittel (3) der nicht umkehrbaren Verbindung mindestens eine Lasche (3a) umfassen, die in einer Wand eines Kastenteils (1b) ausgeschnitten ist, und in mindestens ein Loch (3a) des anderen Kastenteils (1a) eingefügt und gegen die Innenseite der Wand dieses anderen Kastenteils (1a) umgeknickt werden kann.

6. Vorrichtung nach einem der Ansprüche 1 bis 5, dadurch gekennzeichnet, dass der Kasten (1) die äusseren Formen des elektrischen Organs (8) annimmt, das er mit einem durchschnittlichen Spiel von weniger als 1 cm, insbesondere zwischen 1 und 5 mm, umgibt.

7. Vorrichtung nach einem der Ansprüche 1 bis 6, dadurch gekennzeichnet, dass sie mindestens eine synthetische Stoffschicht (4) aufweist, die das elektrische Organ (8) abdeckt, zumindest gegenüber dem Anschluss (7) des leitenden Drahts (5) an diesem elektrischen Organ (8), und die zumindest teilweise die Schutzbeschichtung (1, 4) bildet.

8. Vorrichtung nach Anspruch 7, dadurch gekennzeichnet, dass die synthetische Stoffschicht (4) an Ort und Stelle um den Anschluss (7) des elektrischen Organs (8) herum geformt ist, so dass diese synthetische Stoffschicht (4) allein die Schutzbeschichtung bildet.

9. Vorrichtung nach Anspruch 7 oder 8, dadurch gekennzeichnet, dass der synthetische Stoff (4) härtbar ist.

10. Vorrichtung nach einem der Ansprüche 1 bis 9, dadurch gekennzeichnet, dass mindestens eine haftende synthetische Stoffschicht (4) zwischen dem Kasten (1) und dem elektrischen Organ (8) eingefügt ist, um zumindest teilweise die Mittel (2, 3, 4) der nicht demontierbaren Verbindung darzustellen.

11. Vorrichtung nach einem der Ansprüche 7 bis 10, dadurch gekennzeichnet, dass der synthetische Stoff (4) so angeordnet ist, dass er die elektrischen Anschlüsse (7, 9) einbettet - insbesondere zumindest den Anschluss (7) des leitenden Drahts (5) am elektrischen Organ (8).

12. Vorrichtung nach Anspruch 1 und einem der Ansprüche 7 bis 11, dadurch gekennzeichnet, dass der synthetische Stoff (4) ein härtbarer Stoff ist, der durch eine Öffnung (12) des Kastens (1) nach seiner Montage eingespritzt wird.

13. Vorrichtung nach Anspruch 12, dadurch gekennzeichnet, dass der Kasten (1) aus einem synthetischen Stoff besteht, der mit dem haftenden synthetischen Stoff (4) kompatibel ist, um eine starke Haftung herzustellen.

14. Vorrichtung nach einem der Ansprüche 1 bis 13, dadurch gekennzeichnet, dass die Steuermittel (10) zur kontrollierten Verwendung ein mechanisches Schloss (10) oder mit einem elektronischen Schlüssel und/oder über eine codierte Leitung ferngesteuerte Mittel aufweist.

15. Vorrichtung nach einem der Ansprüche 1 bis 14, dadurch gekennzeichnet, dass die Schaltermittel (9) einen bistabilen Schalter mit zwei Anschlussklemmen (11) aufweisen, um auf dem leitenden Draht (5) in Reihe angeordnet zu werden.

16. Vorrichtung nach einem der Ansprüche 1 bis 15, dadurch gekennzeichnet, dass der Kasten (1) eine Aussparung (15) zur Einführung einer Befestigungslasche (16) am Gerät aufweist.

17. Vorrichtung nach einem der Ansprüche 1 bis 16, dadurch gekennzeichnet, dass sie einen internen elektronischen Schaltkreis (19) umfasst, der bei Auftreten von mindestens einem vorbestimmten Ereignis die automatische Umschaltung der Schaltermittel (9) in die inaktive Position auslöst.

18. Fahrzeug - insbesondere einschliesslich mit zwei Rädern - mit Motor, dadurch gekennzeichnet, dass es mit einer Vorrichtung nach einem der Ansprüche 1 bis 17 ausgerüstet ist.
